(19)

Europäisches Patentamt
European Patent Office
Office européen des brevets

(11) **EP 2 204 476 B1**

(12) **EUROPEAN PATENT SPECIFICATION**

(45) Date of publication and mention of the grant of the patent:
**08.02.2017 Bulletin 2017/06**

(51) Int Cl.:
***C30B 15/00*** *(2006.01)*     ***C30B 29/06*** *(2006.01)*
***C30B 33/02*** *(2006.01)*

(21) Application number: **09014967.5**

(22) Date of filing: **02.12.2009**

(54) **METHOD OF MANUFACTURING A SILICON WAFER**

HERSTELLUNGSVERFAHREN FÜR SILICIUMWAFER

PROCÉDÉ DE FABRICATION D'UNE TRANCHE DE SILICIUM

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **26.12.2008 JP 2008332424**

(43) Date of publication of application:
**07.07.2010 Bulletin 2010/27**

(73) Proprietor: **Siltronic AG**
**81737 München (DE)**

(72) Inventors:
• **Fukuda, Masayuki**
**743-0072 Hikari,**
**Yamaguchi (JP)**
• **Nakai, Katsuhiko**
**743-0071 Hikari,**
**Yamaguchi (JP)**

(56) References cited:
**EP-A1- 1 914 795**     **WO-A1-2008/136500**
**JP-A- 2008 166 721**     **US-A- 4 437 922**
**US-A1- 2007 240 628**

EP 2 204 476 B1

## Description

## Technical field

The present invention relates to a method of manufacturing a silicon wafer which can suppress occurrences of slip dislocation and warpage in the field of a semiconductor wafer manufacturing technique, in particular, in a device manufacturing process.

## Background art

A silicon wafer used as a substrate of a semiconductor device or the like is manufactured by slicing a silicon single-crystal ingot and performing a heat treatment, mirror-like finishing, and the like. As a method of manufacturing a silicon single-crystal ingot, for example, a Czochralski method (to be referred to as a CZ method hereinafter) is given. The CZ method occupies a large part of manufacturing of a silicon single-crystal ingot because a large-diameter single-crystal ingot can be easily obtained and defect can be relatively easily controlled.

In a silicon single crystal (to be referred to as "CZ-Si" hereinafter) pulled up by the CZ method, a crystal defect called a grown-in defect is present. The CZ-Si includes oxygen between lattices in an oversaturated state. However, the oversaturated oxygen causes a microscopic defect called a Bulk Micro Defect (to be referred to as a "BMD" hereinafter) by a heat treatment (annealing) performed later.

In order to form a semiconductor device in a silicon wafer, a crystal defect is required not to be present in a semiconductor device forming region. When a crystal defect is present on a surface for forming a circuit, the defective portion causes a circuit breakdown or the like. On the other hand, an appropriate number of BMDs are required to be present in the silicon wafer. This is because the BMDs function to getter a metal impurity or the like which causes a semiconductor device malfunction.

In order to satisfy the above request, a method which performs high-temperature annealing to the silicon wafer to induce the BMD in the silicon wafer to form an Intrinsic Gettering layer (to be referred to as an "IG layer" hereinafter), eliminates a grown-in defect being present on the surface of the silicon wafer, and forms a Denuded Zone (to be referred to as a "DZ layer" hereinafter) layer having an extremely small number of crystal defects is used.

As a concrete example, a method (JP10-98 047) which performs high-temperature annealing to a nitrogen-containing substrate to reduce grown-in defects on the surface and forms BMDs having nitrogen as cores in the substrate, is proposed.

However, the DZ layer formed on the upper and lower surfaces of the silicon wafer by the high-temperature annealing process has an oxygen concentration which is extremely low because of outward diffusion of oxygen during heat treatment. As a result, prohibitive power of dislocation defect extension on the upper and lower surfaces of the wafer. For this reason, due to micro-scratches on the upper and lower surfaces caused in the annealing step, dislocation defects (to be referred to as "slip" hereinafter) easily extends in a bulk. The extension of the slip dislocation undesirably decreases the strength of the silicon wafer. For example, when a wafer is annealed while being supported by a heat treatment port or the like, a slip dislocation frequently extends from a supported portion on a peripheral portion on the lower surface of the wafer. The slip dislocation may extend from a silicon wafer edge.

When the strength of the silicon wafer is deteriorated, the wafer may be damaged during the manufacturing steps, or the wafer may be broken down. However, the DZ layer is indispensable to manufacturing of a semiconductor device. A silicon wafer having a DZ layer and an excellent strength characteristic is desired.
In the conventional technique described in JP10-98 047 A2, deterioration of strength of a silicon wafer is not considered. A silicon wafer formed by the above method cannot avoid extension of slip dislocation.

On the other hand, in order to prevent occurrence of the slip dislocation, a method which generate BMDs at a high concentration is also proposed.

More specifically, a silicon wafer manufacturing method in which a rapid heat raising/falling temperature heat treatment is performed to a substrate cut out of a silicon single-crystal ingot in an atmosphere of a gas mixture of a nitrogen gas or an inert gas or an ammonia gas and an inert gas at a temperature of 500°C or more to 1200°C or less for 1 minute or more to 600 minutes or less to form oxygen deposition cores each having a size of 20 nm or less in a BMD layer at a concentration of $1 \times 10^{10}/cm^3$ or more is proposed (JP2006-40 980 A2). A silicon wafer manufacturing method in which a heat treatment is performed to a silicon wafer having an oxygen concentration of $1.2 \times 10^{18}$ atoms/$cm^3$ to $1.4 \times 10^{18}$ atoms/$cm^3$ and a carbon concentration of $0.5 \times 10^{16}$ atoms/$cm^3$ to $2 \times 10^{17}$ atoms/$cm^3$ in a non-oxidizing atmosphere under the conditions: a temperature of 1100°C to 1250°C; 1 hour to 5 hours; and a temperature raising rate of 0.1 to 1°C/minute in a temperature range of 1100°C to 1250°C to form BMDs each having a size of 150 nm or less at a concentration of $5 \times 10^9/cm^3$ or more is proposed (JP2006-269 896 A2). A silicon wafer in which a heat treatment is repeated several times to generate BMDs at a high concentration ($1 \times 10^{10}/cm^3$ to $1 \times 10^{12}/cm^3$) is proposed (JP8-213 403 A2). Furthermore, a silicon wafer in which BMDs each of which is located at a position having a depth of 50 $\mu$m

from a surface and has a size of 10 nm or more to 50 nm or less are formed at a concentration of 5 x 10^{11}/cm³ to suppress slip and warpage is also proposed (JP2008-160 069 A2 and JP2008-166 721 A2). Finally, WO 2008/136500 A1 discloses a silicon wafer containing BMDs of an octahedral shape which are present at a depth greater than 50 μm from the surface of the silicon wafer and have a diagonal size of 10 nm to 50 nm and a density of equal to or more than 1x10^{12}/cm³.

However, in recent years, when a silicon wafer increases in diameter, and when an integration density of semiconductor device patterns increases, in addition to occurrence of slip dislocation, warpage occurring in a wafer becomes problematic.

As heat treatment furnaces, a batch type heat treatment furnace and an RTA are known. Slip is brought from a contact between the lower surface of a silicon wafer edge and a silicon wafer holding portion or a silicon wafer edge portion. The brought slip extends in [110] direction, and, depending on circumstances, the silicon wafer may be damaged or broken down. Warpage is a phenomenon in which a silicon wafer is deformed by thermal distortion in a heat treatment. A warpage of a silicon wafer before a heat treatment to give desired characteristics is performed is suppressed to 10 μm or less. However, the heat treatment is performed, a level difference between a peak and a trough reaches several ten micrometers. A semiconductor device pattern cannot be exposed on a wafer surface correctly to cause a decrease in yield of semiconductor devices.

The problem of the warpage is conspicuous when a wafer diameter is 200 mm or more. In particular, a problem caused by a warpage in a batch type heat treatment cannot be solved without giving attention to a BMD concentration and a size of a surface layer. As described above, even though BMDs are merely regulated to be formed at a position having a depth of 50 μm or more and to have small sizes, the problem cannot be avoided.

**Disclosure of the invention**

**Problem to be solved by the invention**

A problem to be solved by the invention is to provide a method of manufacturing a silicon wafer which has a DZ layer having an appropriate area and controls a BMD concentration which can suppress occurrences of slip dislocation and warpage in device manufacturing processes.

**Means for solving the problem**

The present inventors perform faithful research to solve the problem. As a result, the present inventors obtained the following knowledge to get the present invention. That is, of BMDs immediately under a DZ layer, BMDs each having a size of 200 μm or more are controlled at a concentration of 2 x 10^9/cm³ or less, and in a bulk at a depth of 50 μm or more, BMDs each having a size of 10 nm or more to 50 nm or less are controlled to a density of 1 x 10^{12}/cm³ or more, so that occurrences of slip and warpage caused by a batch type heat treatment furnace in device manufacturing processes can be suppressed.

In a batch type heat treatment, a temperature difference between a wafer peripheral portion and wafer central portion increases. As a result, stress which deforms the wafer into a convex shape or a concave shape acts. The stress acting at this time is zero at a center of thickness and increases toward a portion near the surface of the wafer. On the other hand, as a cause of warpage, dislocation occurring from a BMD is given. When the size of the BMD is large, dislocation easily occurs. Therefore, when a BMD having a large size is present near a surface of a wafer having large stress, dislocation occurs from the BMD, and the wafer is easily warped. The present inventors found that control of a concentration and a size of BMDs being present at a relatively deep position (position having a depth of 50 μm or more) in a wafer was not important to improvement of a warpage characteristic, rather than control of a concentration and a size of BMD near a surface layer (position having a depth of 20 μm or less) was very effective to improve the warpage characteristic. Any one of the conventional techniques described in the mentioned documents does not refer to control of a concentration and a size of BMDs located at a position shallower than a surface by 20 μm or less. For this reason, in the conventional techniques, a wafer warpage characteristic in a batch type heat treatment cannot be improved.

The present invention relates to a method of manufacturing a silicon wafer which deposits BMDs at a high concentration in a bulk to suppress slip dislocation and decreases sizes of BMDs near a surface layer where maximum heat stress is generated in a batch type heat treatment to suppress warpage.

More specifically, the present invention relates to a method according to claim 1.

(C) a temperature falling and extracting step of decreasing a temperature of a furnace at a temperature falling rate of 1°C/minute or more to 10°C/minute or less and extracting the substrate out of the furnace at 600°C or more to 750°C or less to cool the substrate to a room temperature, and

(D) a high-temperature heat treatment of setting the temperature of the furnace to 600°C or more to 750°C or less after the temperature falling and extracting step, inserting the substrate into the furnace, raising the temperature of the furnace in a temperature range of less than 1100°C at a temperature raising rate of 5°C/minute or more to 10°C/minute or less, raising the temperature in a temperature range of 1100°C or more to 1250°C or less at a temperature raising rate of 1°C/minute or more to 2°C/minute or less, holding the temperature at 1000°C or more to 1250°C or less to make a diffusion length of interstitial oxygen 50 $\mu$m or more is performed.

(3) A method of manufacturing the silicon wafer described in the (1), characterized in that
a nitrogen concentration of a substrate is 5 x $10^{14}$ atoms/cm$^3$ or more to 1 x $10^{16}$ atoms/cm$^3$ or less, a carbon concentration is 1 x $10^{15}$ atoms/cm$^3$ or more to 3 x $10^{16}$ atoms/cm$^3$ or less,
a heat treatment including:

(A) a low-temperature heat treatment step of performing a heat treatment in a temperature range of 650°C or more to 750°C or less for a required time of 30 minutes or more to 5 hours or less;
(B) furthermore, a heat treatment which raises a temperature in a temperature range of up to 850°C at a temperature raising rate of 0.5°C/minute or more to 2°C/minute or less; and

A BMD having an octahedral shape means a BMD having a shape surrounded by a plurality of {111} planes and other planes. In general, the shapes includes a shape surrounded by eight {111} planes and a shape surrounded by {111} planes and {100} planes. Planes other than {111} plane and {100} plane may appear.

The shapes of BMDs being present in a wafer also include a plate-like shape other than the octahedral. A plate-like BMD is a BMD having a shape surrounded by two {100} planes which are relatively large and other planes. An inside of the BMD may have a tree-like shape. Discrimination between the octahedral shape and the plate-like shape is performed as follows. Of sizes in a [100] direction and a [010] direction when viewed in a [001] direction, a long size is defined as A, and a short size is defined B. In this case, a shape having a ratio of A/B (to be referred to as an "oblateness" hereinafter) of 1.5 or less is defined as an octahedral, and a shape having a ratio of A/B of larger than 1.5 is defined as a plate-like shape. Since BMD shapes in the silicon wafer fluctuate, determination whether the shape of a BMD being present in a wafer is an octahedral shape or a plate-like shape may be performed as follows. That is, the A/B ratios of a plurality of BMDs at different positions in a wafer are measured, an average of the A/B ratios (to be referred to as an "average oblateness" hereinafter) is calculated, and it is determined whether the value exceeds 1.5. When this value exceeds 1.5, states of distortion acting on crystal lattices around the BMDs are different from each other.

For this reason, an optimum BMD size distribution to suppress occurrences of slip and warpage is different from that in the spirit and scope of the invention.

In the present invention, a diagonal length of an octahedral BMD means a longer one A of lengths in the [100] direction and the [010] direction.

### Effect of the Invention

A silicon wafer manufactured according to the present invention is a silicon wafer having BMDs each having an octahedral shape, BMDs of the BMDs each having a diagonal length of 200 nm or more located at a position shallower than the silicon wafer surface by a depth of 20 $\mu$m or less have a concentration of 2 x $10^9$/cm$^3$ or less, and BMDs of the BMDs each having a diagonal length of 10 nm or more to 50 nm or less located at a position having a depth of 50 $\mu$m or more have a concentration of 1 x $10^{12}$/cm$^3$ or more. For this reason, occurrences of slip and warpage in device manufacturing processes are extremely minimized, the silicon wafer can be prevented from being deteriorated in strength while having a DZ layer, and large-scale (typically, 200 mm) high-quality devices can be manufactured.

In the silicon wafer manufactured according to the present invention, in comparison with a mirror wafer being free from BMDs therein, slip dislocation and warpage do not easily occur, and a high gettering capability can be obtained.

### Best mode to carrying out the invention

The present invention will be described below in detail with reference to embodiments.

### Silicon wafer

A silicon wafer manufactured according to the present invention is characterized in that occurrences of both slip and warpage in device manufacturing processes can be extremely minimized.

The dimensions (diameter and thickness) of a wafer manufactured according to the present invention and the presence/absence of dopant of various elements in the wafer are not limited to specific ones. These characteristic features can be appropriately selected depending on the type of a required semiconductor silicon wafer.

A semiconductor device manufacturing by using the silicon wafer manufactured according to the present invention is not limited to a specific one. The present invention can be applied to manufacturing of various semiconductor devices. More specifically, a silicon wafer manufactured according to the present invention can be widely applied to manufacturing of an epitaxial wafer having a surface on which an epitaxial layer is formed, a silicon on insulator (SOI) wafer, an SIMOX wafer to which an SIMOX (Separation By Implanted Oxygen) process is performed, and an SiGe wafer having a surface on which an SiGe layer is formed.

As the characteristic features of the silicon wafer manufactured according to the present invention, the silicon wafer has BMDs each having an octahedral shape, BMDs of the BMDs each having a diagonal length of 200 nm or more located at a position shallower than the silicon wafer surface by a depth of 20 $\mu$m or less have a concentration of 2 x $10^9$/cm$^3$ or less, and BMDs of the BMDs each having a diagonal length of 10 nm or more to 50 nm or less located at a position having a depth of 50 $\mu$m or more have a concentration of 1 x $10^{12}$/cm$^3$ or more. This is a knowledge which is explained below by the present inventors.

More specifically, in the silicon wafer having BMDs each has an octahedral shape, BMDs located at a position having a depth of 20 $\mu$m from a surface influence a warpage characteristic. Furthermore, BMDs each having a diagonal length of 10 nm or more to 50 nm or less and located at a position having a depth of 50 $\mu$m or more influence a slip suppressing characteristic. In general device manufacturing processes, occurrences of warpage and slip can be extremely minimized. In this manner, even though slip occurs from a wafer support portion in the device manufacturing processes, the slip can be prevented from penetrating a silicon wafer surface. Even though slip occurs from a wafer edge portion, the slip can be prevented from reaching a semiconductor device forming region, and the slip can be prevented from adversely affect the device.

When diagonal lengths of BMDs located at a position having a depth of 50 $\mu$m or more are smaller than 10 nm, or when a concentration of BMDs is smaller than 1 x $10^{12}$/cm$^3$, the BMDs do not easily serve as sufficient barriers to slip propagation. Although the density and diagonal lengths of BMDs which can serve as barriers to slip propagation do not have upper limits, for the reason (will be described later), in a range which can be realized by an actual silicon wafer, the upper limit of the diagonal length of the BMD is 50 nm. More specifically, when BMDs are present at a high concentration, almost all solid solution oxygen is deposited as BMDs. On the other hand, the number of oxygen atoms deposited as BMDs does not exceed the number of oxygen atoms soiled-solved in CZ-Si, and a solid solution oxygen concentration is 1 x $10^{18}$ atoms/cm$^3$ at most. Therefore, when the BMDs are present at a high concentration, the concentration of the oxygen atoms deposited as BMDs may be constant at about 1 x $10^{18}$ atoms/cm$^3$. In this state, when the BMD concentration increases, diagonal lengths decrease. More specifically, the diagonal lengths of BMDs which are present at a certain concentration or more have an upper limit, and the BMDs having a concentration of 1 x $10^{12}$/cm$^3$ cannot be realized by BMDs each having a diagonal length of larger than 50 nm. Therefore, the ranges of the concentration and the diagonal length of BMDs which can suppress slip propagation are 1 x $10^{12}$/cm$^3$ or more and 10 nm or more to 50 nm or less, respectively.

For this purpose, an interstitial oxygen concentration is preferably 5 x $10^{17}$ atoms/cm$^3$ or less. On the other hand, the lower limit of the interstitial oxygen concentration may be about 2 x $10^{17}$ atoms/cm$^3$. The interstitial oxygen concentration cannot be easily further decreased because a very-long-time heat treatment must be performed at a low temperature.

The BMD size distribution and the interstitial oxygen concentration described above are desirably realized over an entire surface of a wafer. However, depending on applications, the distribution and the concentration may be realized in some region. For example, when only a typical slip brought from an edge portion of the wafer is prevented, in a region distanced from a wafer center by 80% or more of a wafer radius, the BMD size distribution and the interstitial oxygen concentration may be able to be realized. This is because a slip brought from the edge portion of the wafer frequently occurs in the region distanced from the wafer center by 80% or more of the wafer radius. In order to prevent only warpage of a typical wafer, the BMD size distribution and the interstitial oxygen concentration may be able to be realized in the inside region having 80% or less of the wafer radius. This is because high-concentration dislocation inside a typical wafer which causes warpage frequently occurs in a region having 80% or less of the wafer radius.

The silicon wafer manufactured according to the present invention is excellent in that slip and warpage occurring in device manufacturing processes are small. More specifically, a silicon wafer manufactured according to the present invention, in particular, a silicon wafer in which BMDs are controlled as described above and an interstitial oxygen concentration is reduced is characterized in that a length of a slip occurring in the following heat treatment is very small (typically, the length of the slip is 10 mm or less, and an amount of warpage obtained after the heat treatment is 10 $\mu$m or less).

More specifically, as a test to evaluate slip and resistance to occurrence of warpage in device manufacturing processes, a heat treatment which holds a furnace temperature at 900°C, inserts a wafer into the furnace, and holds the temperature at 1100°C for 30 minutes.

In the heat treatment, in a temperature range in which slip and warpage easily occur, thermal stress is practically maximum. For this reason, when dislocation is prevented from occurring at a temperature raising/falling rate in the temperature range, it can be said that the silicon wafer manufactured according to the present invention is a silicon wafer in which slip and warpage minimally occur in almost all the device manufacturing processes.

In order to measure the shapes and diagonal lengths of the BMDs and the number of BMDs described above, a known measuring method can be generally used. More specifically, a method performed by a transmission electron microscope (to be referred to as a "TEM" and an infrared interference and a method of Optical Precipitate Profiler (to be referred to as an "OPP" hereinafter) are given.

Methods of measuring and evaluating slip dislocation and an amount of warpage of a wafer are not limited. The slip dislocation and the amount of warpage can be generally measured by a known method. More specifically, an X-ray topograph is used to measure slip dislocation. An amount of warpage can be observed and evaluated by using FT-90A available from NIDAK Corporation.

Furthermore, in order to measure an interstitial oxygen concentration, a Fourier transformation infrared absorption spectroscopy (FTIR) can be used.

## Method of manufacturing silicon wafer

The silicon wafer manufactured according to the present invention has the characteristic features described above. The single crystal growing conditions (crystal pulling rate, crystal cooling rate, crucible rotation, gas flow, and the like) and heat treatment conditions (heat treatment temperature, time, temperature raising/falling, and the like) are appropriately controlled to make it possible to manufacture a silicon wafer having the above characteristic features.

In the present invention, in particular, a heat treatment for a substrate is performed in steps.

In this case, the substrate means a silicon wafer to which a heat treatment is not performed, and also means a substrate which is cut out of a single crystal ingot and to which steps such as chamfering other than the heat treatment are performed.

A limitation of the size (diameter, thickness, and the like) and a limitation of the presence/absence of dopant of various elements are not especially set, the size and the presence/absence of dopant can be appropriately selected depending on the type and performance of a required silicon wafer.

An interstitial oxygen concentration included in a substrate may be an oxygen concentration of contained in a silicon in silicon single crystal growth performed by a CZ method under normal conditions. When the substrate is manufactured by the heat treatment described below, preferably, the concentration falls within a range of $8.0 \times 10^{17}$ atoms/cm$^3$ or more to $9.5 \times 10^{17}$ atoms/cm$^3$ or less. When the oxygen concentration falls out of the range, BMDs are not formed at a high concentration, and BMDs each having a large size undesirably has a high-concentration.

In the present invention, divided heat treatments include (A) a low-temperature heat treatment which performs a heat treatment in a temperature range of 650°C or more to 750°C or less for a required time of 30 minutes or more to 5 hours or less, (B) furthermore, a heat treatment which raises a temperature up to 850°C at a temperature raising rate of 0.5°C/minute or more to 2°C/minute or less, (C) a temperature falling and extracting step decreasing a temperature of a furnace at a temperature falling rate of 1°C/minute or more to 10°C/minute or less after the heat raising step and extract the substrate out of the furnace when the temperature of the furnace is 600°C or more to 750°C or less to cool the substrate to a room temperature, and (D) a high-temperature heat treatment which sets the temperature of the furnace to 600°C or more to 750°C or less after the temperature falling and extracting step, inserts the wafer into the furnace, raising the temperature of the furnace in a temperature range of less than 1100°C at a temperature raising rate of 5°C/minute or more to 10°C/minute or less, raises the temperature in a temperature range of 1100°C or more to 1250°C or less at a temperature raising rate of 1°C/minute or more to 2°C/minute less, and holds the temperature at 1000°C or more to 1250°C or less to make a diffusion length of interstitial oxygen more than 50 μm.

As an alternative to the divided heat treatments, a batch heat treatment includes (A) a low-temperature heat treatment which performs a heat treatment in a temperature range of 650°C or more to 750°C or less for a time of 30 minutes or more to 5 hours or less, (B) furthermore, a heat treatment which raises a temperature up to 800°C at a temperature raising rate of 0.5°C/minute or more to 2°C/minute or less, and (C) furthermore, a high-temperature heat treatment which raises a temperature in a temperature range up to less than 1100°C at a temperature raising rate of 5°C/minute or more to 10°C/minute or less and raises a temperature in a temperature range of 1100°C or more to 1250°C or less at a temperature raising rate of 1°C/minute or more to 2°C/minute or less, and holds a constant temperature at 1000°C or more to 1250°C or less to make a diffusion length of interstitial oxygen more than 50 μm.

In the step (A), since oxygen is not sufficiently diffused when a temperature of a heat treatment is lower then 650°C, it is not preferable that BMD formation does not sufficiently occur. On the other hand, when the temperature exceeds 750°C, the heat treatment rarely influences optimization of BMDs, and waste undesirably increases. Time for the heat treatment is shorter than 30 minutes, time required for BMD core formation is not sufficient. When the time exceeds 5 hours, productivity extremely decreases undesirably.

Furthermore, in the step (B), when a temperature raising rate in the heat raising step is lower than 0.5°C/minutes, a stable temperature increasing rate cannot be secured. When the temperature raising rate exceeds 2°C/minute, deposited BMDs are undesirably eliminated.

Furthermore, the high-temperature heat treatment step (D) is to outwardly diffuse interstitial oxygen to form a DZ layer. In this step, when a retention temperature is lower than 1000°C, it is not preferable in terms of production decrease that a long time is required to outwardly diffuse interstitial oxygen. When the retention temperature exceeds 1250°C, the quality of member in an annealing furnace is extremely deteriorated undesirably. When a diffusion length of the interstitial oxygen is a numerical value calculated on the basis of a temperature and a time in the step. More specifically, the numerical value can be calculated by the following equation (i).

$$\text{Diffusion length (μm) of interstitial oxygen} = 2 \times 10^4 \times (D \times \text{time (second)})^{0.5}$$

where

$$D \ (cm^2/second) = 0.17 \times \exp \ (-2.53 \div 8.62 \times 10^{-5} \div \text{temperature (K))}$$

In this manner, a heat treatment which obtains a diffusion length of more than 50 μm is performed to form a large-sized DZ layer having a width of 5 μm or more.

An extracting step is added to the heat treatment when two heat treatment furnaces are used and when a low-temperature heat treatment and a high-temperature heat treatment are performed in different furnaces, respectively. When the respective heat treatments are advantageously performed in the different furnaces to improve the productivity, the temperature falling and extracting step is preferably added to divide the heat treatments into a low-temperature heat treatment and a high-temperature heat treatment.

A temperature falling rate in the temperature falling and extracting step is preferably 1°C/minute or more to 10°C/minute or less which can be realized by a general furnace. A temperature of the furnace when a substrate is extracted from the furnace is undesirably lower than 600°C because the life of a heater in the furnace is shortened. The temperature undesirably exceeds 750°C because members of the furnace are deteriorated.

A temperature of a furnace when a wafer is inserted in the high-temperature heat treatment is undesirably lower than 600°C and undesirably higher than 750°C for the same reason as the temperature falling and extracting step. A temperature raising rate up to 1100°C is preferably 5°C/minute or more to 10°C/minute or less which can be realized by a general furnace, and a temperature raising rate in a temperature range of 1100°C or more to 1250°C or less is preferably 1°C/minute or more to 2°C/minute or less. A temperature and a range of a diffusion length of oxygen in a heat treatment at 1000°C or more are as described above. A temperature falling speed and a pulling temperature after the high-temperature heat treatment is performed are not limited to specific ones.

An apparatus used in the series of heat treatments described above are not limited to specific one, and a conventional known apparatus is preferably used. More specifically, a normal batch type vertical furnace, a batch type vertical furnace with an oxygen purge function, and the like are given.

In the manufacturing method according to the present invention, the substrate contains nitrogen. This is because the substrate contains nitrogen to suppress warpage to a lower level (typically, 15 μm or less). In this manner, the warpage is further suppressed, so that a higher-performance device can be manufactured.

A concentration of nitrogen added for this purpose is $5 \times 10^{14}$ atoms/cm$^3$ or more to $1 \times 10^{16}$ atoms/cm$^3$ or less. When the concentration exceeds the range, polycrystallization undesirably occurs because a yield may be decreased.

In the manufacturing method according to the present invention, the substrate contains carbon. This is because the substrate contains carbon to advantageously form BMDs even though the low-temperature heat treatment is performed at a low temperature for a comparatively short period of time.

A concentration of carbon added for this purpose is $1 \times 10^{15}$ atoms/cm$^3$ or more to $8.1 \times 10^{15}$ atoms/cm$^3$ or less. When carbon is added at a concentration higher than the above range, a production yield disadvantageously decreases in crystal manufacturing. Furthermore, when concentration is lower than the range, the BMD concentration of a bulk is difficult to be $1 \times 10^{12}$/cm$^3$ or more.

Methods of adding nitrogen and carbon to a substrate are not limited to specific methods, and a conventional known method is preferably used. More specifically, as a method of adding nitrogen, substrate with nitride film is added to a single-crystal pulling melt to make it possible to adjust a nitrogen concentration of the obtained substrate. And as a method of adding carbon powder is added to a single-crystal pulling melt to make it possible to adjust a carbon concentration of an obtained substrate.

Methods of measuring concentrations of nitrogen, carbon, and oxygen contained in a substrate are not limited to specific methods, and the concentrations can be preferably measured by conventional known methods. More specifically, in measurement of a nitrogen concentration, the nitrogen concentration a secondary ion mass analyzing apparatus (SIMS) can be used. The oxygen concentration and the carbon concentration are measured by an infrared absorption method, and can be calculated as converted coefficients by a value of Japan Electronics and Information Technology Industries Association (JEITA).

**Examples**

The present invention will be described below in detail by examples. However, the present invention is not limited to the examples.

**Method of manufacturing annealed wafer**

Single-crystal ingots were manufactured under various conditions (wafer diameter, conductivity type, oxygen, nitrogen, carbon concentration), and the same portions of straight body parts of the single-crystal ingots were cut by using a wire saw. The portions obtained by performing mirror processing having a thickness of 725 μm or more to 750 μm or less were used as substrates. Annealed wafers were manufactured from the substrates by the following method.

**Divided heat treatment**

An obtained substrate was put in a batch type first vertical heat treatment furnace, a low-temperature heat treatment was performed to the substrate. The substrate was put in a second vertical heat treatment furnace, and a high-temperature heat treatment was performed in an argon gas atmosphere. A diffusion length of interstitial oxygen in the high-temperature heat treatment was obtained by integrating the equation (i) according to a temperature pattern of the high-temperature heat treatment. Heat treatment conditions of the examples and comparative examples will be described below.

**Batch Heat Treatment**

An obtained substrate was put in a batch type vertical heat treatment furnace, a low-temperature heat treatment and a high-temperature heat treatment were performed in an argon gas atmosphere in the same furnace. A diffusion length of interstitial oxygen in the high-temperature heat treatment was obtained by integrating the equation (i) according to a temperature pattern of the high-temperature heat treatment. Heat treatment conditions of the examples and the comparative examples will be described below.

**Examples of Heat Treatment**

Examples 1 to 3: at 700°C for 4 hours, temperature was raised to 800°C at 1°C/minute, temperature was decreased at 3°C/minute, substrate was extracted at 700°C and cooled to a room temperature, substrate was inserted at 700°C, temperature was raised to lower than 1100°C at 5°C/minute and to 1100°C or more at 1°C/minute, and kept at 1200°C for 5 hours.

Example 4: at 700°C for 4 hours, temperature was raised to 750°C at 0.5°C/minute, temperature was decreased at 3°C/minute, substrate was extracted at 700°C and cooled to room temperature, substrate was inserted at 700°C, temperature was raised to lower than 1100°C at 5°C/minute and to 1100°C or more at 1°C/minute, and kept at 1200°C for 5 hours.

Example 5: at 700°C for 4 hours, temperature was raised to 800°C at 0.5°C/minute, temperature was raised to 1100°C at 8°C/minute and to 1100°C or more at 1°C/minute, and kept at 1200°C for 5 hours.

Comparative Examples 1 to 4: at 700°C for 4 hours, temperature was raised to 800°C at 1°C/minute, temperature was decreased at 3°C/minute, substrate was extracted at 700°C and cooled to a room temperature, substrate was inserted at 700°C, temperature was raised to lower than 1100°C at 5°C/minute and to 1100°C or more at 1°C/minute, and kept at 1200°C for 1 hour.

Comparative Example 5: at 700°C for 4 hours, substrate was extracted at 700°C and cooled to a room temperature, substrate was inserted at 700°C, temperature was raised to lower than 1100°C at 5°C/minute and to 1100°C or more at 1°C/minute, and kept at 1200°C for 1 hour.

Comparative Example 6: at 700°C for 4 hours, temperature was raised to 800°C at 0.5°C/minute, temperature was decreased at 3°C/minute, substrate was extracted at 700°C and cooled to a room temperature, substrate was inserted at 700°C, temperature raised to lower than 1100°C at 5°C/minute and to 1100°C or more at 1°C/minute, and kept at 1200°C for 1 hour.

Manufacturing conditions of the manufactured wafers (Examples 1 to 5 and Comparative Examples 1 to 6) (wafer diameter, conductivity type, concentrations (nitrogen, oxygen, and carbon) in a substrate, and diffusion lengths of interstitial oxygen in each heat treatment) are listed in Table 1. In this table, a P-type is boron dopant, and N-type is phosphorous dopant. Adjustment and measurement of concentrations of inclusions (oxygen and the like) are performed according to a normal known method.

[Table 1]

| No. | Wafer Diameter (mm) | Conductivity Type | Nitrogen (atoms/cm$^3$) | Oxygen (atoms/cm$^3$) | Carbon (atoms/cm$^3$) | Diffusion Length of **Interstitial** Oxygen in High-temperature Heat Treatment ($\mu$m) |
|---|---|---|---|---|---|---|
| Example **1** | **200** | **P** | **1.3E+15** | **9.2E+17** | **1.5E+15** | **52** |
| Example **2** | **200** | **P** | **1.4E+15** | **9.0E+17** | **3.5E+15** | **52** |
| Example **3** | **200** | N | **1.9E+15** | **9.3E+17** | **2.6E+15** | **52** |
| Example **4** | **200** | **P** | **1.6E+15** | **9.2E+17** | **4.7E+15** | **52** |
| Example **5** | **200** | **P** | **2.4E+15** | **8.8E+17** | **8.1E+15** | **52** |
| Comparative example 1 | **200** | **P** | **1.3E+15** | **9.2E+17** | **1.5E+15** | **23** |
| Comparative example 2 | **200** | N | **1.9E+15** | **9.3E+17** | **2.8E+15** | **23** |
| Comparative example 3 | **200** | **P** | **3.3E+15** | **8.6E+17** | **1.0E+16** | **23** |
| Comparative example 4 | **200** | **P** | **1.4E+15** | **9.0E+17** | **3.5E+ 15** | **23** |
| Comparative example 5 | **200** | **P** | **1.4E+15** | **8.7E+17** | **3.3E+15** | **23** |
| Comparative example 6 | **200** | **P** | **3.2E+15** | **8.6E+17** | **1.3E+16** | **23** |

**Manufacturing conditions of manufactured wafers, and concentrations in substrates**

**Measurement and evaluation of annealed wafer**

Each annealed wafer obtained under the manufacturing conditions was measured and evaluated in the following (1), (2), (3), and (4). TEM samples of samples used in measurements of (1) and (2) was obtained as follows. That is, the wafers were cut down by a precision polisher to predetermined depths (50 $\mu$m, 100 $\mu$m, and 300 $\mu$m), and the samples were obtained from a center portion of the wafer and a portion distanced from an edge by 10 mm. An OPP was set such that a focus is set to predetermined depths (5 $\mu$m and 15 $\mu$m from a surface layer) of the wafers and predetermined positions (center, and 10 mm from edge).

(1) Determination of BMD Shape: the same measurement sample was measured twice while changing a scan direction of an OPP into <110> direction and <100> direction, and (A BMD oblateness was determined) a ratio of signal intensities obtained by both the measurements. More specifically, a relationship between the ratio of the signal intensities and the BMD oblateness was examined in advance, and a oblateness was calculated from the ratio of the signal intensities. Measurement was also performed by a TEM. At this time, the oblateness was measured and calculated from a microscopic image viewed from [001] direction. From these results, BMD shape determination was performed. At least 10 BMDs in each of the samples were measured, and all obtained oblatenesses were averaged to calculate an average oblateness. It was determined whether the average oblatenesses exceeded 1.5.

(2) BMD Size and Concentration: Sizes and concentrations were obtained by measuring a portion having a depth of less than 20 $\mu$m from a surface layer by using an OPP and measuring a portion having a depth of 50 $\mu$m or more by using a TEM. From observation results of the BMDs obtained by the following methods 1) and 2), concentrations of BMDs each having a predetermined size were calculated. As the concentration of BMDs each having the predetermined size, an average value at three portions at a predetermined depth was used.

1) Measurement by OPP: By using an OPP available from AXENT Technologies, a signal intensity obtained by performing signal processing electrically to a phase difference of transmitting lasers caused by BMDs was measured. As measurement range in a direction of depth, a range in a depth of $\pm 5$ $\mu$m from the setting was used. More specifically, when a focus was set at a position in a depth of 5 $\mu$m from a surface, a range from a depth of 0 $\mu$m to 10 $\mu$m was measured. When the focus was set at a position in a depth of 15 $\mu$m from the surface, a range from a depth 10 $\mu$m to 20 $\mu$m was measured. In size correction of BMDs was performed as follows. That is, BMDs each having known sizes were measured by an OPP, and a correction curve of the signal intensities and BMD sizes was formed. The correction curve will be described below.

$$BMD\ diagonal\ length\ (nm)\ having\ an\ octahedral\ shape = 153\ x\ (OPP\ signal)^{0.43}$$

By using the correction curve, BMD sizes were calculated from signal intensities. In calculation of the sizes, a ghost signal removing process (K. Nakai Review of Scientific Instruments, vol. 69 (1998) pp. 3283) was performed. A detection sensitivity was set to a sensitivity at which a BMD having a diagonal length of 80 nm or more could be measured.

2) Measurement by TEM: from a microscopic image obtained by measurement, a concentration of BMDs each having a predetermined size was calculated. The concentration was calculated from the number of BMDs observed in a field of view and a volume of a sample corresponding to an observed region.

(3) Nitrogen Concentration of Annealed Wafer

A sample was extracted from an annealed wafer and polished by 20 $\mu$m to remove a nitrogen outward diffusion layer on the surface. Thereafter, a nitrogen concentration was measured.

**Slip length of annealed wafer and warpage resistance**

**Evaluation**

A heat treatment (to be referred to as a "pseudo device process heat treatment" hereinafter) described in the following (4) was performed to an annealed wafer. Warpages of the annealed wafer before the pseudo device process heat treatment and after the pseudo device process heat treatment were measured by FT-90A available from NIDEK corporation to calculate an increase in warpage = warpage after heat treatment - warpage before heat treatment. An annealed wafer after the pseudo device process heat treatment was observed by an X-ray topograph, and a maximum length of lengths of observed slips was defined as a typical value.

(4) Heat Treatment using Batch Type Heat Treatment Furnace

(I): Holds a furnace temperature at 900°C, and a wafer is inserted into the furnace

(II): Holds a temperature at 900°C for 30 minutes in an oxygen gas atmosphere, and then extract the wafer at 900°c

**Measurement results and evaluation results of annealed wafers**

In Table 2, as examples and comparative examples, with respect to annealed wafers manufactured under the manufacturing conditions shown in Table 1, measured concentrations of BMDs each having a predetermined size and slips and amounts of warpage occurring in the pseudo device process heat treatment are listed. The wafer manufactured under any of the conditions has a BMD average oblateness was 1.5 or less.

[Table 2]

[Table 2]

| No. | Wafer Diameter (mm) | Conductivity Type | Nitrogen (atoms/cm$^3$) | Oxygen (atoms/cm$^3$) | Carbon (atoms/cm$^3$) | Diffusion length of **Interstitial** Oxygen in High-temperature Heat treatment($\mu$m) | BMD Concentration | | Slip (mm) | Amount of Warpage ($\mu$m) |
|---|---|---|---|---|---|---|---|---|---|---|
| | | | | | | | 1 Surface Layer from 0 to 20 $\mu$m (1/cm$^3$) | 2 Inside Bulk (1/cm$^3$) | | |
| | | | | | | | 200nm$\leq$ | 10nm$\leq$ 50nm$\geq$ | | |
| Example 1 | 200 | P | 1.3E+15 | 9.2E+17 | 1.5E+15 | 52 | 1.1E+09 | 2.0E+12 | 7.8 | 13 |
| Example 2 | 200 | P | 1.4E+15 | 9.0E+17 | 3.5E+15 | 52 | 2.0E+09 | 3.2E+12 | 4.7 | 0.0 |
| Example 3 | 200 | N | 1.9E+15 | 9.3E+17 | 2.6E+15 | 52 | 1.9E+09 | 2.2+12 | 8.7 | 1.5 |
| Example 4 | 200 | P | 1.6E+15 | 9.2E+17 | 4.7E+15 | 52 | 1.6E+09 | 3.0E+12 | 8.2 | 1.7 |
| Example 5 | 200 | P | 2.4E+15 | 8.8E+17 | 8.1E+15 | 52 | 1.8E+09 | 3.0E+1.2 | 0.9 | 6.4 |
| Comparative example 1 | 200 | P | 1.3E+15 | 9.2E+17 | 1.5E+15 | 23 | 5.2E+09 | 2.0E+12 | 5.5 | 14.6 |
| Comparative example 2 | 200 | N | 1.9E+15 | 9.3E+17 | 2.6E+15 | 23 | 7.9E+09 | 2.4E+12 | 5.8 | 39.6 |
| Comparative example 3 | 200 | P | 3.3E+15 | 8.6E+17 | 1.0E+16 | 23 | 9.1E+09 | 2.4E+12 | 7.0 | 99.1 |
| Comparative example 4 | 200 | P | 1.4E+15 | 9.0E+17 | 3.5E+15 | 23 | 6.2E+09 | 3.0E+12 | 2.9 | 33.3 |
| Comparative example 5 | 200 | P | 1.4E+15 | 8.7E+17 | 3.3E+15 | 23 | 8.4E+08 | 4.8E+11 | 12.5 | 6.0 |
| Comparative example 6 | 200 | P | 32E+15 | 8.6E+17 | 1.3E+16 | 23 | 7.1E+09 | 7.6E+11 | 11.0 | 722 |

In this case, a "surface layer" of a BMD concentration in Table 2 is a concentration of BMDs each having a size of 200 nm or more, and an "inside bulk" of the BMD concentration means a concentration of BMDs each having a size of 10 nm or more to 50 nm or less. A value of a concentration of the "surface layer" is a sum of concentrations measured at a depth of 5 $\mu$m and a depth of 15 $\mu$m.

According to these results, the followings were obtained.

(i) A surface layer of a BMD concentration is 2 x $10^9$/cm$^3$ or less, an inside bulk of the BMD concentration is 1 x $10^{12}$/cm$^3$ or more. For this reason, a slip length is 10 mm or less, and an amount of warpage is suppressed to 10 $\mu$m or less.

(ii) A nitrogen concentration of an annealed wafer added with nitrogen was not different from a nitrogen concentration measured in a substrate.

(iii) Slips and warpages of a P-type and an N-type were not different from each other.

(iv) The same effects were obtained in the divided heat treatments and the batch heat treatment.

(v) Even in wafers in which nitrogen, oxygen, and carbon concentrations in a substrate were same, both of slip characteristic and warpage could be satisfied when the diffusion length of Interstitial Oxygen was set to 50 $\mu$m.

(vi) Even in wafers in which nitrogen, oxygen, and carbon concentrations in a substrate were same, only one of slip characteristic or warpage could be satisfied by changing of the low-temperature heat treatments. However, both characteristic could not be simultaneously satisfied.

**Claims**

1. A method of manufacturing a silicon wafer having BMDs each having an octahedral shape, BMDs of the BMDs each having a diagonal length of 200 nm or more located at a position shallower than the silicon wafer surface by a depth of 20 $\mu$m or less having a concentration of not more than 2 x $10^9$/cm$^3$, and BMDs of the BMDs each having a diagonal length of 10 nm or more to 50 nm or less located at a position having a depth of 50 $\mu$m or more having a concentration of 1 x $10^{12}$/cm$^3$ or more, the method comprising
providing a silicon substrate having a nitrogen concentration which is 5 x $10^{14}$ atoms/cm$^3$ or more to 1 x $10^{16}$ atoms/cm$^3$ or less, and having a carbon concentration which is 1 x $10^{15}$ atoms/cm$^3$ or more to 8.1 x $10^{15}$ atoms/cm$^3$ or less,
subjecting the silicon substrate wafer either to divided heat treatments or to a batch heat treatment in an argon gas atmosphere;
the divided heat treatments including:

(A) a low-temperature heat treatment step of performing a heat treatment in a temperature range of 650°C or more to 750°C or less for a required time of 30 minutes or more to 5 hours or less;
(B) furthermore, a heat treatment which raises a temperature in a temperature range of up to 850°C at a temperature raising rate of 0.5°C/minute or more to 2°C/minute or less;
(C) a temperature falling and extracting step of decreasing a temperature of a furnace at a temperature falling rate of 1°C/minute or more to 10°C/minute or less after the heat raising step and extracting the substrate out of the furnace when the temperature of the furnace is 600°C or more to 750°C or less to cool the substrate to a room temperature; and
(D) a high-temperature heat treatment which sets the temperature of the furnace to 600°C or more to 750°C or less after the temperature falling and extracting step, inserts the substrate into the furnace, raising the temperature of the furnace in a temperature range of less than 1100°C at a temperature raising rate of 5°C/minute or more to 10°C/minute or less, raises the temperature in a temperature range of 1100°C or more to 1250°C or less at a temperature raising rate of 1°C/minute or more to 2°C/minute or less, and holds the temperature at 1000°C or more to 1250°C or less at least a time to make a diffusion length of interstitial oxygen, DLO($\mu$m), more than 50 $\mu$m, the time being calculated according to equation

$$\mathrm{DLO(\mu m)} \ = \ 2 \ \mathrm{x} \ 10^4 \ \mathrm{x} \ (\mathrm{D(cm^2/s)} \ \mathrm{x} \ \mathrm{time(s)})^{0.5},$$

where

$$\mathrm{D(cm^2/s)} \ = \ 0.17 \ \mathrm{x} \ \exp(-2.53 \ : \ 8.62 \ \mathrm{x} \ 10^{-5} \ : \ \mathrm{temperature(K))};$$

and

the batch heat treatment including:

(A) a low-temperature heat treatment step of performing a heat treatment in a temperature range of 650°C or more to 750°C or less for a required time of 30 minutes or more to 5 hours or less;
(B) furthermore, a heat treatment which raises a temperature in a temperature range of up to 850°C at a temperature raising rate of 0.5°C/minute or more to 2°C/minute or less; and
(C) furthermore, a high-temperature heat treatment in which a heat raising process up to less than 1100°C is performed at a temperature raising rate of 5°C/minute or more to 10°C/minute or less and in a temperature range of 1100°C or more to 1250°C or less at a temperature raising rate of 1°C/minute or more to 2°C/minute or less, and the temperature is held at 1000°C or more to 1250°C or less at least a time to make a diffusion length of interstitial oxygen, DLO($\mu$m), more than 50 $\mu$m, the time being calculated according to equation

$$DLO(\mu m) = 2 \times 10^4 \times (D \times time(s))^{0.5},$$

where

$$D(cm^2/s) = 0.17 \times exp(-2.53 : 8.62 \times 10^{-5} : temperature(K)).$$

**Patentansprüche**

1. Verfahren zum Herstellen eines Siliziumwafers mit Sauerstoffpräzipitaten (BMDs - Bulk Microdefects) jeweils mit einer oktaedrischen Form, wobei BMDs der BMDs jeweils mit einer Diagonallänge von 200 nm oder weniger sich an einer Position flacher als die Siliziumwaferoberfläche um eine Tiefe von 20 $\mu$m oder weniger mit einer Konzentration von höchstens 2 x 10$^9$/cm$^3$ befinden und BMDs der BMDs jeweils mit einer Diagonallänge von 10 nm oder mehr bis 50 nm oder weniger sich an einer Position mit einer Tiefe von 50 $\mu$m oder mehr mit einer Konzentration von 1 x 10$^{12}$/cm$^3$ oder mehr befinden, wobei das Verfahren Folgendes umfasst:

Bereitstellen eines Siliziumsubstrats mit einer Stickstoffkonzentration, die 5 x 10$^{14}$ Atome/cm$^3$ oder mehr bis 1 x 10$^{16}$ Atome/cm$^3$ oder weniger beträgt, und mit einer Kohlenstoffkonzentration, die 1 x 10$^{15}$ Atome/cm$^3$ oder mehr bis 8,1 x 10$^{15}$ Atome/cm$^3$ oder weniger beträgt,
Unterziehen des Siliziumsubstratwafers entweder unterteilten Wärmebehandlungen oder einer Chargenwärmebehandlung in einer Argongasatmosphäre;
wobei die unterteilten Wärmebehandlungen Folgendes beinhalten:

(A) einen Niedertemperaturwärmebehandlungsschritt des Durchführens einer Wärmebehandlung in einem Temperaturbereich von 650°C oder mehr bis 750°C oder weniger für eine erforderliche Zeit von 30 Minuten oder mehr bis 5 Stunden oder weniger;
(B) weiterhin eine Wärmebehandlung, die eine Temperatur in einem Temperaturbereich von bis zu 850°C mit einer Temperaturanstiegsrate von 0,5°C/Minute oder mehr bis 2°C/Minute oder weniger anhebt;
(C) einen Temperaturabfall- und Extrahierungsschritt des Senkens einer Temperatur eines Ofens mit einer Temperaturabfallrate von 1°C/Minute oder mehr bis 10°C/Minute oder weniger nach dem Wärmeanstiegsschritt und Extrahieren des Substrats aus dem Ofen, wenn die Temperatur des Ofens 600°C oder mehr bis 750°C oder weniger beträgt, um das Substrat auf eine Raumtemperatur abzukühlen; und
(D) eine Hochtemperaturwärmebehandlung, die die Temperatur des Ofens auf 600°C oder mehr bis 750°C oder weniger nach dem Temperaturabfall- und Extrahierungsschritt einstellt, das Substrat in den Ofen einsetzt, die Temperatur des Ofens in einem Temperaturbereich von weniger als 1100°C mit einer Temperaturanstiegssrate von 5°C/Minute oder mehr bis 10°C/Minute oder weniger anhebt, die Temperatur in einem Temperaturbereich von 1100°C oder mehr bis 1250°C oder weniger mit einer Temperaturanstiegsrate von 1°C/Minute oder mehr bis 2°C/Minute oder weniger anhebt und die Temperatur auf 1000°C oder mehr bis 1250°C oder weniger zumindest während einer Zeit hält, um eine Diffusionslänge von interstitiellem Sauerstoff, DLO ($\mu$m), mehr als 50 $\mu$m zu machen, wobei die Zeit gemäß folgender Gleichung berechnet wird

$$DLO\ (\mu m)\ =\ 2\ x\ 10^4\ x\ (D(cm^2/s)\ x\ Zeit(s))^{0,5},$$

wobei

$$D(cm^2/s)\ =\ 0,17\ x\ Exp\ (-2,53\ :\ 8,62\ x\ 10^{-5}\ :\ Temperatur(K));$$

und
die Chargenwärmebehandlung Folgendes beinhaltet:

(A) einen Niedertemperaturwärmebehandlungsschritt des Durchführens einer Wärmebehandlung in einem Temperaturbereich von 650°C oder mehr bis 750°C oder weniger für eine erforderliche Zeit von 30 Minuten oder mehr bis 5 Stunden oder weniger;
(B) weiterhin eine Wärmebehandlung, die eine Temperatur in einem Temperaturbereich von bis zu 850°C mit einer Temperaturanstiegsrate von 0,5°C/Minute oder mehr bis 2°C/Minute oder weniger anhebt; und
(C) weiterhin eine Hochtemperaturwärmebehandlung, bei der ein Wärmeanstiegsprozess von bis zu unter 1100°C mit einer Temperaturanstiegsrate von 5°C/Minute oder mehr bis 10°C/Minute oder weniger und in einem Temperaturbereich von 1100°C oder mehr bis 1250°C oder weniger mit einer Temperaturanstiegsrate von 1°C/Minute oder mehr bis 2°C/Minute oder weniger durchgeführt wird und die Temperatur bei 1000°C oder mehr bis 1250°C oder weniger mindestens während einer Zeit gehalten wird, um eine Diffusionslänge von interstitiellem Sauerstoff, DLO ($\mu$m), mehr als 50 $\mu$m zu machen, wobei die Zeit gemäß folgender Gleichung berechnet wird

$$DLO\ (\mu m)\ =\ 2\ x\ 10^4\ x\ (D\ x\ Zeit(s))^{0,5},$$

wobei

$$D(cm^2/s)\ =\ 0,17\ x\ Exp\ (-2,53\ :\ 8,62\ x\ 10^{-5}\ :\ Temperatur(K)).$$

**Revendications**

1. Procédé de fabrication d'une tranche de silicium ayant des microdéfauts volumiques (BMD) ayant chacun une forme octaédrique, les BMD parmi les BMD ayant chacun une longueur en diagonale de 200 nm ou plus situés à une position sous la surface de la tranche de silicium jusqu'à une profondeur de 20 $\mu$m ou moins ayant une concentration ne dépassant pas $2x10^9/cm^3$, et les BMD parmi les BMD ayant chacun une longueur en diagonale de 10 nm ou plus à 50 nm ou moins situés à une position ayant une profondeur de 50 $\mu$m ou plus ayant une concentration de $1x10^{12}/cm^3$ ou plus, le procédé comprenant les étapes suivantes :

se procurer un substrat de silicium ayant une concentration d'azote qui est de $5x10^{14}$ atomes/$cm^3$ ou plus à $1x10^{16}$ atomes/$cm^3$ ou moins, et ayant une concentration de carbone qui est de $1x10^{15}$ atomes/$cm^3$ ou plus à $8,1x10^{15}$ atomes/$cm^3$ ou moins,
soumettre le substrat de silicium en tranche à des traitements thermiques séparés ou à un traitement thermique discontinu dans une atmosphère d'argon gazeux ;
les traitements thermiques séparés comportant :

(A) une étape de traitement thermique à basse température consistant à effectuer un traitement thermique dans une fourchette de températures de 650 °C ou plus à 750 °C ou moins pendant un temps nécessaire de 30 minutes ou plus à 5 heures ou moins ;
(B) de plus, un traitement thermique qui fait monter une température dans une fourchette de températures allant jusqu'à 850 °C à une vitesse de montée en température de 0,5 °C/minute ou plus à 2 °C/minute ou moins ;

(C) une étape de chute de température et d'extraction consistant à faire baisser une température d'un four à une vitesse de chute de température de 1 °C/minute ou plus à 10 °C/minute ou moins après l'étape de montée en température et extraire le substrat du four quand la température du four est de 600 °C ou plus à 750 °C ou moins pour refroidir le substrat jusqu'à une température ambiante ; et

(D) un traitement thermique à haute température qui règle la température du four à 600 °C ou plus à 750 °C ou moins après l'étape de chute de température et d'extraction, insère le substrat dans le four, fait monter la température du four dans une fourchette de températures de moins de 1100 °C à une vitesse de montée en température de 5 °C/minute ou plus à 10 °C/minute ou moins, fait monter la température dans une fourchette de températures de 1100 °C ou plus à 1250 °C ou moins à une vitesse de montée en température de 1 °C/minute ou plus à 2 °C/minute ou moins, et maintient la température à 1000 °C ou plus à 1250 °C ou moins au moins le temps de rendre une longueur de diffusion de l'oxygène interstitiel, DLO ($\mu$m), supérieure à 50 $\mu$m, le temps étant calculé selon l'équation

$$ \text{DLO } (\mu m) = 2 \times 10^{4} \times (D \ (cm^{2}/s) \times \text{temps } (s))^{0,5}, $$

où

$$ D(cm^{2}/s) = 0,17 \times \exp(-2,53 : 8,62 \times 10^{-5} : \text{température } (K)) \ ; $$

et

le traitement thermique discontinu comportant :

(A) une étape de traitement thermique à basse température consistant à effectuer un traitement thermique dans une fourchette de températures de 650 °C ou plus à 750 °C ou moins pendant un temps nécessaire de 30 minutes ou plus à 5 heures ou moins ;

(B) de plus, un traitement thermique qui fait monter une température dans une fourchette de températures allant jusqu'à 850 °C à une vitesse de montée en température de 0,5 °C/minute ou plus à 2 °C/minute ou moins ;

(C) de plus, un traitement thermique à haute température dans lequel un procédé de montée en température jusqu'à moins de 1100 °C est effectué à une vitesse de montée en température de 5 °C/minute ou plus à 10 °C/minute ou moins et dans une fourchette de températures de 1100 °C ou plus à 1250 °C ou moins à une vitesse de montée en température de 1 °C/minute ou plus à 2 °C/minute ou moins, et la température est maintenue à 1000 °C ou plus à 1250 °C ou moins au moins le temps de rendre une longueur de diffusion de l'oxygène interstitiel, DLO ($\mu$m), supérieure à 50 $\mu$m, le temps étant calculé selon l'équation

$$ \text{DLO } (\mu m) = 2 \times 10^{4} \times (D \times \text{temps } (s))^{0,5}, $$

où

$$ D(cm^{2}/s) = 0,17 \times \exp(-2,53 : 8,62 \times 10^{-5} : \text{température } (K)). $$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10098047 A
- JP 2006040980 A
- JP 2006269896 A
- JP 8213403 A
- JP 2008160069 A
- JP 2008166721 A
- WO 2008136500 A1

**Non-patent literature cited in the description**

- **K. NAKAI.** *Review of Scientific Instruments,* 1998, vol. 69, 3283